# EUROPEAN PATENT APPLICATION

(11) **EP 4 560 339 A1**
(43) Date of publication of application: **28.05.2025**
(21) Application number: 23212018.8
(22) Date of filing: 24.11.2023
(51) Int. Cl.: G01R 31/64

(54) **METHOD FOR DIAGNOSING AT LEAST ONE SUPERCAPACITOR**

(71) Applicant: Kiekert AG, 42579 Heiligenhaus (DE)
(72) Inventor: Merletti, Marco, 21045 Gazzada Schianno (Varese) (IT)
(74) Representative: Michalski Hüttermann & Partner Patentanwälte mbB

(57) **Abstract**

The invention relates to a method for diagnosing at least one supercapacitor (3) configured for actuating an electronically actuated door latch (2) of a motor vehicle (8), comprising the following steps: measuring an open load voltage and an open load current of the at least one supercapacitor (3) during open load of the at least one supercapacitor (3), measuring a load voltage and a load current of the at least one supercapacitor (3) during discharging the at least one supercapacitor (3), establishing a functional dependency between the open load voltage, the open load current, the load voltage and the load current, and determining a diagnostic value based on the functional dependency. In this way an easy, cheap and reliable solution for diagnosing a supercapacitor in an electronically actuated door latch is provided.

## Description

### Technical Field

The invention relates to a method for diagnosing at least one supercapacitor configured for actuating an electronically actuated door latch of a motor vehicle. The invention further relates to a door latch arrangement for a motor vehicle, the door latch arrangement (comprising an electronically actuated door latch, at least one supercapacitor configured for actuating the door latch and a computing device.

### Background Art

Several automotive systems require presence of a backup energy source in a motor vehicle that can provide electrical energy, either as a substitute or as a backup for a motor vehicle's main power source in case the main power source fails or is interrupted. Typically, this backup power source is charged from a motor vehicle's main power system during normal operation so that the backup power source is ready for immediate use when needed, such as in an event of an accident or a motor vehicle malfunction.

With an increasing use of electronically actuated door latches, often referred to as eLatches, in place of conventional mechanical latches, a significant safety concern arises in an event that the main power source is not available. Especially in cases where mechanical bowden cables or levers for electronically actuated door locks no longer exist, opening a door of the motor vehicle without power can be a major challenge. Such a scenario can occur after an accident or damage to the motor vehicle.

Current state of the art involves the use of supercapacitors as energy storage devices as backup power source in emergency situations. During power losses, for example when an accident happened, the supercapacitor may deliver energy for operating the electronically actuated door latch.

Supercapacitors, also known as ultracapacitors or super-caps, are special electrical energy storage devices capable of storing and releasing large amounts of electrical energy in a short period of time. Unlike conventional batteries, supercapacitors are based on a completely different principle. The supercapacitor generally has two electrodes made of conductive material. Carbon materials such as activated carbon are often used because they provide a large surface area for adsorption of ions. The electrodes are separated by an electrolyte that serves as an ion conductor. The electrolyte is a conductive liquid or gel that allows ion movement between the electrodes. A separator between the two electrodes prevents direct electrical contact between them and ensures electrical isolation, and such wise prevents a short circuit in the supercapacitor. Such structure is typically housed in a case that protects and insulates the components.

The charging and discharging process of a supercapacitor is based on the separation and movement of ions in the electrolyte. When a supercapacitor is charged, positive ions are bound to one electrode while negative ions are simultaneously bound to the other electrode. This process results in the storage of electrical energy in the form of ions. During the discharge process, the ions are released and the stored energy is discharged.

Despite the long lifetime of supercapacitors, the electrolyte of the supercapacitors can dry out for various reasons, such as the expiration of the supercapacitor's lifetime, which is influenced by environmental conditions and the supercapacitor's charge and discharge cycles, among other factors. This in turn limits the functionality of the supercapacitor. The limited functionality of the supercapacitor can lead to problems opening the door in an emergency, especially if the motor vehicle is involved in an accident or is damaged. In such situations, it is critical that the emergency opening mechanisms in place work.

### Summary of invention

It is therefore an object of the invention to provide an easy, cheap and reliable solution for diagnosing a supercapacitor in an electronically actuated door latch.

The object of the invention is solved by the features of the independent claims. Preferred implementations are detailed in the dependent claims.

Thus, the object is solved by a method for diagnosing at least one supercapacitor configured for actuating an electronically actuated door latch of a motor vehicle, comprising the following steps:
measuring an open load voltage and an open load current of the at least one supercapacitor during open load of the at least one supercapacitor,
measuring a load voltage and a load current of the at least one supercapacitor during discharging the at least one supercapacitor,
establishing a functional dependency between the open load voltage, the open load current, the load voltage and the load current, and
determining a diagnostic value based on the functional dependency.

Here, the open load is understood as the load in which basically or no discharge of the at least one supercapacitor takes place in the electronically actuated door latch of the motor vehicle. The load voltage and the load current, on the other hand, are measured during the discharge of the at least one supercapacitor. It is preferable that a difference between the open load voltage and the load voltage, and between the open load current and the load current is significant in order to ensure a more accurate measurement.

Employing the functional dependency established on the basis of the measured values of open load voltage and current, and load voltage and current, the diagnostic value is determined, which allows the functionality of the at least one supercapacitor to be assessed. It is essential to the invention that the measured voltages and currents enable the diagnostic value of the at least one supercapacitor to be determined. This makes it possible, for example, to carry out the measurements in the electronically actuated door latch itself.

In contrast thereto, conventional solutions only know how to test the supercapacitor on a test bench under controlled conditions. This is an extremely complicated and time-consuming measurement for determining the diagnostic value, since the electronically actuated door latch would have to be removed from the motor vehicle and the at least one supercapacitor would also have to be removed from the electronically actuated door latch in order to test its functionality and determine the diagnostic value. Furthermore, in the case of several supercapacitors, it is accordingly provided that a separate diagnostic value is determined for each supercapacitor.

This determination of the diagnostic value is preferably carried out each time the motor vehicle is started to ensure that the motor vehicle is running with a functioning emergency release of the electronically actuated door latch.

In general, different functional dependencies can be established to determine different diagnostic values of the at least one supercapacitor. According to a preferred implementation of the invention, however, the functional dependency comprises the difference between the open load voltage and the load voltage and between the open load current and the load current. In this context it is particularly preferred, according to an implementation of the invention, that the diagnostic value is a resistance of an equivalent series resistor of the at least one supercapacitor.

By differentiating the respective open load and load currents and the respective open load and load voltages, a respective delta is determined that directly allows to determine the diagnostic value corresponding to the resistance of an equivalent series resistor of the at least one supercapacitor by means of Ohm's law. Capacitors and inductors as used in electric circuits are not ideal components with only capacitance or inductance. However, Capacitors and inductors can be treated, to a very good degree of approximation, as being ideal capacitors and inductors in series with a resistance; this resistance is defined as the equivalent series resistance (ESR).

In general, it is possible to assess the diagnostic value using different values. According to a preferred implementation of the invention, however, the step of determining the diagnostic value comprises: comparing the diagnostic value with at least one reference value of the at least one supercapacitor.

The comparison of the diagnostic value with at least one reference value of the at least one supercapacitor allows the functionality of the supercapacitor or its remaining lifetime to be assessed by comparison. In the present case, the reference value is the value which, in the case of comparable supercapacitors, permits an assessment of the remaining lifetime of the at least one supercapacitor. These reference values are therefore known values for the at least one supercapacitor, which are used to assess the further lifetime of the at least one supercapacitor. The reference value is therefore a value that has been determined under controlled conditions and serves as an indicator for comparison with the diagnostic value.

It is possible to make the reference value comparable with the diagnostic value in different ways. According to a preferred implementation of the invention, however, the at least one reference value is stored in a lookup table, which is preferably provided within the electronically actuated door latch. Since the reference values are stored in the lookup table in the electronically actuated door latch, they are compared directly with the diagnostic value. The more reference values are in the lookup table, the more accurate the diagnosis regarding the functionality of the at least one supercapacitor or the remaining lifetime of the at least one supercapacitor.

In this context, it is therefore particularly preferred according to a preferred implementation of the invention that the method comprising the following further steps of: determining a remaining lifetime of the at least one supercapacitor based on the comparison with the at least one reference value, and outputting the remaining lifetime of the at least one supercapacitor.

The diagnostic value of the at least one supercapacitor compared with the reference values thus allows the remaining lifetime of the at least one supercapacitor to be determined. Values corresponding to the remaining lifetime of the at least one supercapacitor can also be listed in the lookup table, so that the nearest reference value is identified on the basis of the diagnostic value and this in turn is directly linked to the corresponding value of the remaining lifetime, which can be a time in days and/or a distance that can still be covered with the motor vehicle.

Likewise, it may be provided that the reference value is interpolated with the remaining lifetime if the determined diagnostic value does not correspond exactly to the reference value. A corresponding interpolation can be linear, cubic or another suitable dimension or underlying function.

However, for safety reasons, it is also possible to always output a lower remaining lifetime than the remaining lifetime actually resulting from the determined diagnostic value.

A remaining lifetime output can then be transmitted wirelessly directly to a workshop or read out by a cable connection when the motor vehicle is in the workshop. In addition or instead, the remaining lifetime can be shown to a driver of the motor vehicle on a display in the motor vehicle itself.

In principle, the load voltage and the load current can be measured at different discharge states of the at least one supercapacitor. According to a preferred implementation of the invention, however, the measurement of the load voltage and the load current is carried out during actuating the door latch, such that a voltage and current measurement of the at least one supercapacitor is performed under full load.

In this case, the full load current and voltage measurement refers to the measurement taken at the highest possible load applied to the supercapacitor. In other words, the moment at which the door handle is opened with the help of the supercapacitor. Measuring during the full load when activating the electronically actuated door latch ensures that the diagnostic value is determined immediately before the motor vehicle is entered.

Further, the object is further solved by a door latch arrangement for a motor vehicle is provided, the door latch arrangement comprising an electronically actuated door latch, at least one supercapacitor configured for actuating the door latch and a computing device, wherein the computing device is adapted for measuring an open load voltage and an open load current during an open load of the at least one supercapacitor and a load voltage and a load current during discharging the at least one supercapacitor, the computing device being adapted for establishing a functional dependency between the open load voltage, the open load current, the load voltage and the load current, and the computing device being further adapted for determining a diagnostic value based on the functional dependency.

The computing device is thus configured and connected to the at least one supercapacitor in such a way that the measurements of the open load voltage and the open load current as well as the measurement of the load voltage and the load current are enabled. Further, the computing device establishes the functional dependency based on the measured voltages and currents and further determines the diagnostic value based on this functional dependency. This determination of the diagnostic value can therefore be carried out entirely within the motor vehicle and therefore enables the remaining lifetime of the at least one supercapacitor to be estimated independently of work-shops.

Basically, it is possible to provide the computing device in different ways. According to a preferred implementation of the invention, however, the computing device comprises a microcontroller and an analog-to-digital converter, wherein the microcontroller is adapted to perform the measurements and is connected to the analog-to-digital converter for transmitting the measured values, wherein the analog-to-digital converter is connected to the microcontroller for transmitting digitized measured values, and the microcontroller is configured for establishing the functional dependency on the basis of the digitized measured values and for determining the diagnostic value based on the functional dependency.

The microcontroller is preferably provided as a compact electronic component that is designed as part of the computing device. The microcontroller is used to measure open load voltage and current as well as load voltage and load current. These analog measured values are then converted into digital open load voltage and open load current as well as load voltage and load current by the analog-to-digital converter. The microcontroller then processes these digital voltages and currents to establish the functional dependency and from that then determine the diagnostic value. Similarly, the microcontroller can exchange information with other devices or systems via various interfaces, such as serial communication, USB, Ethernet or wireless communication (e.g. Bluetooth or WLAN) .

However, instead of the microcontroller, a field programmable gate array (FPGA) is provided in another preferred implementation of the invention. The FPGA is an integrated circuit or semiconductor device with digital logic circuits specifically designed for the required applications.

Flash memory may be provided on the microcontroller or FPGA to store the lookup table that allows comparison of the diagnostic values to the reference data. However, according to a preferred implementation of the invention, the computing device further comprises a data storage, the computing device being adapted for comparing the diagnostic value with a plurality of reference values in the data storage, and for determining and outputting the remaining lifetime of the supercapacitor based on the comparison. Since the data storage is not part of the microcontroller, it can be in the form of a memory card or similar, which is removably connected to the microcontroller via an interface. Thus, the lookup table can be updated or changed. At the same time, the remaining lifetime can be adapted to new findings or the like.

The invention further concerns the use of the door latch arrangement according to the above on a door of a motor vehicle.

Further implementations and advantages of the door latch arrangement can be derived by the person skilled in the art from the method as described before.

### Brief description of drawings

These and other aspects of the invention will be apparent from and elucidated with reference to the implementation described hereinafter.

In the drawings:

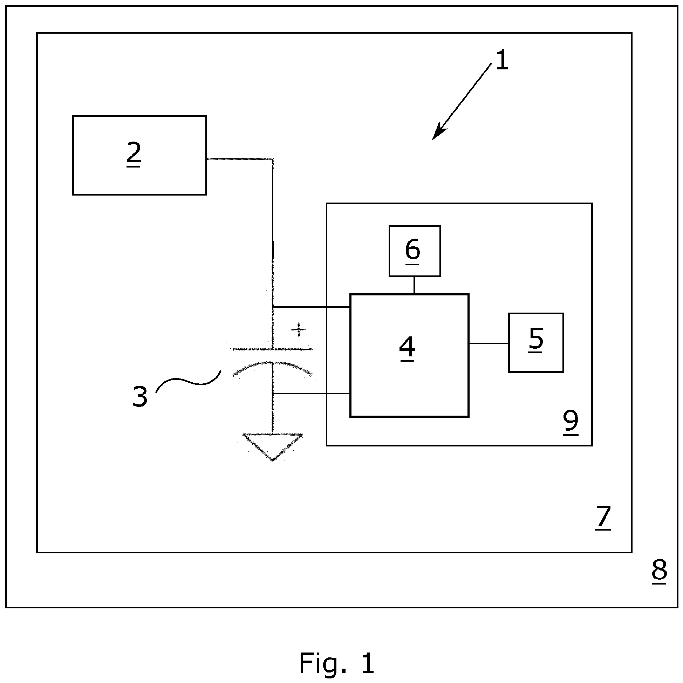

- Fig. 1: schematically depicts a door latch arrangement with an electronically actuated door latch according to a preferred implementation of the invention.

### Description of implementations

Fig. 1 schematically depicts a door latch arrangement 1 according to a preferred implementation of the invention. The door latch arrangement 1 has an electronically actuated door latch 2 that is galvanically connected to a supercapacitor 3. A computing device 9 is connected in parallel with the supercapacitor 3. The computing device 9 has a microcontroller 4, which in turn is connected to an analog-to-digital converter 5 and a data storage 6. The door latch arrangement 1 is installed in a door 7 of a motor vehicle 8.

When the door latch 2 is activated, a full load measurement of a load current and a load voltage is performed by the microcontroller 4 on the supercapacitor 3 in the computing device 9. If there is no load on the supercapacitor 3, or if it is fully charged, the microcontroller 4 performs an open load measurement of an open load current and an open load voltage on the supercapacitor 3. The microcontroller 4 uses the analog-to-digital converter 5 to convert the analog measured values into digital values. With the differences of the open load, load voltage and the open load, load current, an equivalent series resistance is determined, which corresponds to a diagnostic value. Finally, the microcontroller 4 compares the diagnostic value with a reference value of a lookup table contained in the data storage 6 to determine the remaining lifetime of the supercapacitor 3.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### List of reference signs

- 1: Door latch arrangement
- 2: door latch
- 3: supercapacitor
- 4: microcontroller
- 5: analog-to-digital converter
- 6: data storage
- 7: door
- 8: motor vehicle
- 9: computing device

## Claims

1. Method for diagnosing at least one supercapacitor (3) configured for actuating an electronically actuated door latch (2) of a motor vehicle (8), comprising the following steps:
measuring an open load voltage and an open load current of the at least one supercapacitor (3) during open load of the at least one supercapacitor (3),
measuring a load voltage and a load current of the at least one supercapacitor (3) during discharging the at least one supercapacitor (3),
establishing a functional dependency between the open load voltage, the open load current, the load voltage and the load current, and
determining a diagnostic value based on the functional dependency.

2. Method according to the preceding claim, wherein the functional dependency comprises a difference between the open load voltage and the load voltage and between the open load current and the load current.

3. Method according to one of the preceding claims, wherein the diagnostic value is a resistance of an equivalent series resistor of the at least one supercapacitor (3) .

4. Method according to any one of the preceding claims, wherein the step determining the diagnostic value comprises:
comparing the diagnostic values with at least one reference value of the at least one supercapacitor (3).

5. Method according to the preceding claim, wherein the at least one reference value is stored in a lookup table, which is preferably provided within the electronically actuated door latch (2).

6. Method according to any one of the two preceding claims, comprising the following further steps:
determining a remaining lifetime of the at least one supercapacitor (3) based on the comparison with the at least one reference value, and
outputting the remaining lifetime of the at least one supercapacitor (3).

7. Method according to any one of the preceding claims, wherein measuring the load voltage and the load current is carried out during actuating the electronically actuated door latch (2) such that a voltage and current measurement of the at least one supercapacitor (3) is performed under full load.

8. Door latch arrangement (1) for a motor vehicle (8), the door latch arrangement (1) comprising an electronically actuated door latch (2), at least one supercapacitor (3) configured for actuating the door latch (2) and a computing device (9), wherein
the computing device (9) is adapted for measuring an open load voltage and an open load current during an open load of the at least one supercapacitor (3) and a load voltage and a load current during discharging the at least one supercapacitor (3),
the computing device (9) being adapted for establishing a functional dependency between the open load voltage, the open load current, the load voltage and the load current, and
the computing device (9) being further adapted for determining a diagnostic value based on the functional dependency.

9. Door latch arrangement (1) according to the preceding claim, wherein
the computing device (9) comprises a microcontroller (4) and an analog-to-digital converter (5),
the microcontroller (4) is adapted to perform the measurements and is connected to the analog-to-digital converter (5) for transmitting the measured values,
the analog-to-digital converter (5) is connected to the microcontroller (4) for transmitting digitized measured values, and
the microcontroller (4) is configured for establishing the functional dependency on basis of the digitized measured values and for determining the diagnostic value based on the functional dependency.

10. Door latch arrangement (1) according to claims 8 or 9, wherein
the computing device further comprises a data storage (6),
the computing device (9) is adapted for comparing the diagnostic value with a plurality of reference values in the data storage (6), and for determining and outputting the remaining lifetime of the supercapacitor (3) based on the comparison.

11. Use of the door latch arrangement (1) according to any one of the claims 8 to 10 in and/or on a door (7) of the motor vehicle (8).
